# EUROPÄISCHE PATENTSCHRIFT

(11) **EP 1 711 915 B1**
(45) Veröffentlichungstag und Bekanntmachung des Hinweises auf die Patenterteilung: **14.07.2010**
(21) Anmeldenummer: 05701285.8
(22) Anmeldetag: 01.02.2005
(51) Int. Cl.: G06K 19/077

(54) **VERFAHREN UND VORRICHTUNG ZUM KONTINUIERLICHEN HERSTELLEN ELEKTRONISCHER FOLIENBAUTEILE SOWIE ELEKTRONISCHES FOLIENBAUTEIL**
METHOD AND DEVICE FOR CONTINUOUSLY PRODUCING ELECTRONIC FILM COMPONENTS, AND AN ELECTRONIC FILM COMPONENT
PROCEDE ET DISPOSITIF POUR PRODUIRE EN CONTINU DES COMPOSANTS ELECTRONIQUES A COUCHE MINCE, ET COMPOSANT ELECTRONIQUE A COUCHE MINCE

(30) Priorität: 04.02.2004 DE 102004006457
(43) Veröffentlichungstag der Anmeldung: 18.10.2006
(73) Patentinhaber: bielomatik Leuze GmbH + Co. KG, 72639 Neuffen (DE)
(72) Erfinder: BOHN, Martin, 72762 Reutlingen (DE)
(74) Vertreter: Thul, Hermann
(86) Internationale Anmeldenummer: PCT/EP2005/000951
(87) Internationale Veröffentlichungsnummer: WO 2005/076206

(56) Entgegenhaltungen:
- DE-A1- 10 205 914
- FR-A- 2 775 810
- US-A1- 2003 064 544
- US-A1- 2003 214 792
- PATENT ABSTRACTS OF JAPAN Bd. 2003, Nr. 06, 3. Juni 2003 (2003-06-03) -& JP 2003 044803 A (TOPPAN FORMS CO LTD), 14. Februar 2003 (2003-02-14)

## Beschreibung

Die Erfindung betrifft ein Verfahren zum kontinuierlichen Herstellen elektronischer Folienbauteile in Form von Transpondern, bei denen Chipmodule mit ihren elektrischen Anschlusskontakten auf Antennenanschlüsse von Antennenfolienabschnitten aufgebracht werden, ein Verfahren zum kontinuierlichen Herstellen elektronischer Folienbauteile in Form von Chipmoduletiketten, eine Vorrichtung zur Durchführung eines solchen Verfahrens, mit einer Chipmodulstation, an der die Chipmodule gespeichert sind, sowie mit einer Haftfolienstation, an der die Haftfolienbahn rollenförmig vorgelegt ist, und ein elektronisches Folienbauteil.

Ein Verfahren und eine Vorrichtung zur kontinuierlichen Transponderherstellung sind aus der DE 101 20 269 C1 bekannt. Bei dem bekannten Verfahren werden Chipmodule auf einem Trägerband gehalten. Es ist eine Antennenfolienbahn vorgesehen, die mit einer Vielzahl von in einer Reihe hintereinander angeordneten Antennenfolienabschnitten versehen ist. Jeder Antennenfolienabschnitt weist Antennenanschlüsse auf, mit denen elektrische Anschlusskontakte der Chipmodule verbunden werden müssen. Die Chipmodule werden von dem Trägerband abgelöst und gleichzeitig auf die Anschlusskontakte der Antennenfolienabschnitte aufgebracht und gemeinsam mit der Antennenfolienbahn aufgewickelt. Die Anschlusskontakte der Chipmodule werden durch eine Laserverlötung mit den Antennenanschlüssen verbunden. Alternativ ist es auch möglich, die Anschlusskontakte der Chipmodule durch Crimpung mit den Antennenanschlüssen zu verbinden. Die Verlötung bzw. die Vercrimpung der Chipmodule mit den Antennenfolienabschnitten ist derart ausgeführt, dass sowohl die elektrische Kontaktierung als auch die Lagefixierung der Chipmodule relativ zu den Antennenanschlüssen erzielt wird.

Aus der FR-A-2775810 ist ein Verfahren bekannt, bei denen die Chipmodule mit ihrer den Anschlusskontakten abgewandten Rückseite auf Haftfolienabschnitte aufgebracht werden, deren Grundfläche wesentlich größer ist als eine Grundfläche jedes Chipmoduls. Die Chipmodule werden in einer festgestellten Position lagefixiert, und die Haftfolienabschnitte werden flächig mit den Antennenfolienabachnitten verbunden.

Aufgabe der Erfindung Ist es, ein Verfahren, eine Vorrichtung sowie ein elektronisches Folienbauteil der eingangs erwähnten Art zu schaffen, die mit einfachen Mitteln eine sichere Funktion der Folienbauteile gewährleisten.

Für das Verfahren zur Transponderhersteilung wird diese Aufgabe mit den Merkmalen des Patentanspruchs 1 gelöst.

Durch die erfindungsgemäße Lösung werden die Chipmodule mit den Antennenanschlüssen ausschließlich elektrisch kontaktiert, ohne dass diese Kontaktierung auch eine Fixierung der Chipmodule relativ zu den Antennenfolienabschnitten erzielen muss. Denn die Lagefixierung der Chipmodule relativ zu den Antennenfolienabschnitten wird durch die Haftfollenabschnitte erzielt, die um das jeweilige Chipmodul herum flächig mit den Antennenfolienabschnitten verbunden werden und so das Chipmodul in seiner Positionierung an den Antennenanschlüssen fixieren. Die Chipmodule werden somit durch den Haftfolienabschnitt an dem jeweiligen Antennenfolienabschnitt fixiert. Die Chipmodule selbst übernehmen vor allem die elektrische Kontaktlerung mit den Antennenanschlüssen, ohne dass diese Kontaktierung auch eine selbstständige Lagefixierungsfunktion erzielen muss. Die elektrische Kontaktierung kann durch mechanische Verbindung leitfähiger Teile der Anschlusskontakte und der Antennenanschlüsse oder auch durch stoffschlüssige leitfähige Verbindung wie Löten, leitfähige Zwischenmedien, wie leitfähiger Klebstoff oder ähnliches erfolgen. Die gegenüber dem Stand der Technik zusätzlich vorgesehene Haftfolien bahn bzw. die entsprechenden Haftfolienabschnitte schaffen nicht nur eine sichere und gleichbleibende Lagefixierung der Chipmodule, sondern bilden gleichzeitig auch noch eine Schutzfolie für das Chipmodul und für das durch das Chipmodul und den entsprechenden Antennenfolienabschnitt gebildete, elektronische Folienbauteil. Vorzugsweise sind die Haftfolienabschnitte in ihren Abmessungen auf die Antennenfolienabschnitte abgestimmt. In vorteilhafter Weise sind die Haftfolienabschnitte so groß bemessen, dass in jedem Fall eine Antennenstruktur des jeweiligen Antennenfolienabschnittes verdeckt wird. Jedes Chipmodul ist zwischen den beiden elektrischen Anschlusskontakten elektrisch isoliert, so dass bei der Kontaktierung der Anschlusskontakte mit den Antennenanschlüssen keine unerwünschten Kurzschlussbrücken entstehen können. Dies vereinfacht die Antennenherstellung, da die Windungen der Antenne auf eine Seite aufgebracht werden können (vorzugsweise bei gedruckten Antennen). Auch die Antennenanschlüsse sind zueinander beabstandet und in dem vorhandenen Zwischenraum elektrisch isoliert. Ein Chipmodul besteht aus einem Mikrochip und einer Modulbrücke, die die elektrischen Anschlusskontakte des Chipmoduls bildet und mit der der Mikrochip entsprechend leitfähig verbunden ist. Zur elektrischen Kontaktierung der Anschlusskontakte der Chipmodule mit den Antennenanschlüssen werden die Anschlusskontakte vorzugsweise mit Kontaktspitzen versehen, die an den Modulbrücken entweder vorab in einem separaten Verfahrensgang oder direkt kontinuierlich während des erfindungsgemäßen Verfahrens erzeugt werden. Die Antennenfolienabschnitte werden vorzugsweise dadurch gebildet, dass in eine Folienbahn, vorzugsweise eine Papierbahn, entsprechende Antennenstrukturen eingedruckt werden. Alternativ können die Antennenstrukturen auch durch Abätzen entsprechender Beschichtungen gebildet werden. Die erfindungsgemäße Lösung eignet sich insbesondere zur Herstellung von Transpondern, die als Sicherheitslabels für Verpackungen, als Sicherungsetiketten zur Auszeichnung und/oder Individualisierund von Produkten und ähnliches eingesetzt werden. Die Haftfolienbahn bildet eine Decklage der elektronischen Folienbauteile.

In Ausgestaltung der Erfindung sind die Antennenfolienabschnitte Teil einer Antennenfolienbahn, wobei jeder Antennenfolienabschnitt eine auf der Antennenfolienbahn aufgebrachte Antennenstruktur aufweist. Die Antennenstruktur wird vorzugsweise aufgedruckt. Alternativ kann sie durch Ätzen geschaffen werden.

In weiterer Ausgestaltung erfolgt die Unterteilung der Haftfolienbahn in einzelne Haftfollenabschnitte zeitlich vor dem elektrischen Kontaktieren der Chipmodule mit den Antennenanschlüssen. In beiden Fällen werden die Haftfolienabschnitte kontinuierlich derart synchron zu der Antennenfolienbahn gefördert, dass sich die Anschlusskontakte der Chipmodule jewells exakt auf Höhe der Antennenanschlüsse der Antennenstrukturen der Antennenfolienabschnitte befinden. Dadurch kann bei kontinuierlichem Vorschub der Antennenfolienbahn eine exakte elektrische Kontaktierung der Chipmodule auf den Antennenfolienabschnitten erfolgen. Gleichzeitig oder unmittelbar anschließend erfolgt die Fixierung der Chipmodule durch das Aufdrücken der Haftfolienabschnitte auf die Antennenfolienabschnitte. Vorzugsweise sind die Haftfolienabschnitte mit einer Klebeschicht versehen, die flächig mit der Antennenfolienbahn verklebt wird. Da die Chipmodule gegenüber den Antennenfolienabschnitten geringfügig nach oben abragen, spannt sich jeder Haftfolienabschnitt zwangsläufig über das Chipmodul und presst dieses gegen die Antennenfolienbahn. Vorzugsweise wird die Haftfolienbahn bereits nach dem Aufbringen der Chipmodule auf die Haftfolienbahn, aber vor dem Kontaktieren der Chipmodule auf der Antennenfolienbahn in die einzelnen Haftfolienabschnitte vereinzelt. Hierzu sind vorzugsweise rotierende Schneidwerkzeuge vorgesehen, die im kontinuierlichen Verfahren die Haftfolienbahn in die einzelnen Haftfolienabschnitte unterteilt, bevor diese mit den Antennenfolienabsch nitten der Antennenfolienbahn verbunden werden. Die Haftfolienbahn kann insbesondere bei dem Verfahren zur Chipmoduletikettenherstellung mit einer Stanzstruktur versehen sein, die nach Art eines folienförmigen Stanzgitters nach dem Verbinden der Haftfolienabschnitte mit der Schutzfolienbahn abgezogen werden kann.

In weiterer Ausgestaltung der Erfindung werden die Kontaktspitzen der elektrischen Anschlusskontakte der Chipmodule mechanisch in die elektrisch leitfähigen Antennenanschlüsse eingedrückt. Die mechanische Verbindung dient in erster Linie dazu, die elektrische Kontaktierung der Chipmodule mit den Antennenanschlüssen herzustellen. Denn die Fixierung der Chipmodule auf der Antennenfolienbahn erfolgt - wie bereits beschrieben - durch die Haftfolienabschnitte.

In weiterer Ausgestaltung der Erfindung werden die Haftfolienbahn und die Schutzfolienbahn flächig miteinander verbunden und in einer Verbundfolienbahn auf eine Rolle aufgewickelt, die Verbundfolienbahn wird von der Rolle abgewickelt und die Haftfolienbahn und die Schutzfolienbahn werden vor dem Aufbringen der Chipmodule voneinander abgezogen und unterschiedlichen Bahnverläufen zugeführt. Die Schutzfolienbahn bildet eine Trägerlage für die Haftfolienbahn und schützt die Haftfolienbahn und die Chipmodule vor Beschädigung. Gleichzeitig bildet die Schutzfolienbahn die nichtklebende Schutzlage für die Haftfolienbahn, um eine Verschmutzung der Klebeschicht zu vermeiden.

In weiterer Ausgestaltung der Erfindung werden die mittels der Haftfolienabschnitte auf die Antennenfolienabschnitte der Antennenfolienbahn aufgebrachten Chipmodule gemeinsam mit der Antennenfolienbahn auf eine Rolle aufgewickelt. Dadurch ist eine einfache und sichere Lagerung der elektronischen Folienbauteile erreichbar. Vorzugsweise wird vor dem Aufwickeln der Chipmodule gemeinsam mit der Antennenfolienbahn die elektrische/elektronische Funktion der Folienbauteile überprüft. Dadurch ist es möglich, funktionslose Folienbauteile oder mit einer Fehlfunktion versehene Transponder zu kennzeichnen, um diese in einem späteren Verfahrensschritt aussortieren zu können.

In weiterer Ausgestaltung der Erfindung werden die elektrischen Anschlusskontakte der Chipmodule und/oder die Antennenanschlüsse mit im wesentlichen pyramidenförmigen, harten und leitfähigen Partikeln versehen, die derart ausgerichtet sind, dass Spitzen der Pyramiden in Richtung des korrespondierenden Anschlusses zeigen. Dies erhöht die Qualität einer elektrischen Kontaktierung, da aufgrund des an einer Pyramidenspitze während eines Kontaktierungsvorgangs herrschenden hohen Drucks die Spitze in das sich verformende Material des korrespondierenden Verbindungspartners eindringt und somit eine leitende elektrische Verbindung erzeugt.

In weiterer Ausgestaltung der Erfindung wird vor dem elektrischen Kontaktieren der elektrischen Anschlusskontakte der Chipmodule mit den Antennenanschlüssen und vor dem Verbinden der Haftfolienabschnitte mit den Antennenfolienabschnitten ein Klebemittel derart auf die Antennenfolienabschnitte aufgebracht, dass sich nach dem elektrischen Kontaktieren und dem Verbinden eine Klebemittelschicht bildet, deren minimale Ausdehnung durch die Grenzflächen zwischen den Chipmodulen und den Antennenfolienabschnitten festgelegt wird und deren maximale Ausdehnung durch die Grenzflächen zwischen den Haftfolienabschnitten und den Antennenfolienabschnitten festgelegt wird. Dies führt zu einer Verbesserung der Klebekraft und somit zu einer sichereren Fixierung der Chipmodule relativ zu den Antennenanachlüssen.

In weiterer Ausgestaltung der Erfindung wird nach dem elektrischen Kontaktieren der elektrischen Anschlusskontakte der Chipmodule mit den Antennenanschlüssen und nach dem Verbinden der Haftfolienabschnitte mit den Antennenfolienabschnitten auf den Antennenfolienabschnitten eine Trägerlage, insbesondere eine Sillkonträgerlage, aufgebracht und/oder auf den Haftfollenabschnitten eine Decklage aufgebracht. Auf diese Weise kann ein Folienbauteil in einfacher Weise zuverlässig gelagert und bei Bedarf von der Silikonträgerlage abgelöst und beispielsweise auf eine Verpackung aufgeklebt werden.

Für die Vorrichtung zur Durchführung des Verfahrens, die mit einer Chipmodulstation, an der die Chipmodule gespeichert sind, versehen ist, wird die der Erfindung zugrunde liegende Aufgabe dadurch gelöst, dass eine Haftfolienstation vorgesehen ist, an der die Haftfolienbahn rollenförmig vorgelegt ist, und dass eine Übergabestation vorgesehen Ist, an der die Chipmodule vereinzelt mit ihrer Rückseite auf die Haftflächenseite der Haftfolienbahn aufgebracht werden, wobei die Abstände der Chipmodule bei der Aufbringung auf die Haftfolienbahn derart groß gewählt sind, dass jewells ein das zugehörige Chipmodul umgebender Haftfolienabschnitt wesentlich großflächiger ist als die Grundfläche des jeweiligen Chipmoduls. Ein Haftfollenabschnitt ist auf seiner der Antennenfolienbahn zugewandten Innenseite durchgängig mit der Klebeschicht versehen, und es sind Mittel vorhanden, den Haftfollenabschnitt flächig mit der Oberseite der Antennenfolienbahn um das Chipmodul herum zu verkleben, um den Kontakt zwischen den Chipmodulen und den Antennenstrukturen zu sichern. Alternativ ist entweder eine Schutzfolienbahn an einer Verbundstation oder eine Antennenfolienbahn an einer Antennenfolienstation vorzugsweise rollenförmig vorgelegt. Durch die beschriebene Lösung ist gewährleistet, dass der entsprechende Haftfolienabschnitt eine sichere Fixierung des jeweiligen Chipmoduls auf einer Schutzfolienbahn (Chipmoduletikett) oder auf einem zugehörigen Antennenfolienabschnitt (Transponder) der Antennenfolienbahn erzielt. Durch die rollenförmige Vorlage der Haftfolienbahn und der Antennenfolienbahn oder der Schutzfolienbahn ist ein kontinuierlicher Abzug der Bahnen von den entsprechenden Rollen erzielbar. Dies ermöglicht eine kontinuierliche Herstellung der Folienbauteile. Dadurch ist es möglich, in relativ kurzer Zeit eine große Anzahl entsprechender Folienbauteile, seien es Transponder mit Antennenstruktur oder Chipmoduletiketten ohne Antennenstruktur, zu erzeugen.

Die Vorrichtung arbeitet im Rolle/Rolle-Verfahren und ermöglicht so eine kontinuierliche Verarbeitung der einzelnen Komponenten der Folienbauteile. Erfindungsgemäß ist die Haftung und damit die Fixierung der Chipmodule und die Schaffung der elektrischen Leitfähigkeit zwischen Chipmodulen und Antennenstrukturen auf zwei unterschiedliche Bereiche verteilt. Die erfindungsgemäße Lösung eignet sich insbesondere zur Herstellung von Etiketten mit elektronischer Funktion, insbesondere mit elektronischer Sicherungs- oder Identifizierungsfunktion.

In Ausgestaltung der Erfindung ist eine Kontaktierungsstation zum kontinuierlichen mechanischen Kontaktieren der elektrischen Anschlusskontakte der Chipmodule mit Antennenanschlüssen von Antennenfolienabschnitten der Antennenfolienbahn vorgesehen. An dieser Kontaktierungsstation werden vorzugsweise bereits vorhandene Kontaktspitzen der Anschlusskontakte der Chipmodule mit den Antennenanschlüssen der Antennenfolienbahn verbunden. Die Kontaktierungsstation dient dazu, die elektrische Kontaktierung der Chipmodule mit den Antennenanschlüssen vorzunehmen.

In weiterer Ausgestaltung der Erfindung ist eine Haftstation vorgesehen, an der über die Chipmodule hinausragende Haftfolienabschnitte flächig mit den Antennenfolienabschnitten verbunden werden, auf denen das jeweilige Chipmodul elektrisch kontaktiert ist. Vorzugsweise sind die Haftstation und die Kontaktierungsstation in einer gemeinsamen Einheit der Vorrichtung integriert, um zumindest im Wesentlichen zeitgleich die elektrische Kontaktierung und die Fixierung der Chipmodule erzielen zu können.

In weiterer Ausgestaltung der Erfindung ist die Breite der Haftfolienbahn größer als die Breite der Haftfolienabschnitte. Dadurch ist es möglich, die Haftfolienbahn mit einer Stanzstruktur zu versehen und ein entsprechendes Stanzgitter als Abfall nach der Verbindung der Haftfolienbahn mit der Schutzfolienbahn abzuziehen und dadurch zwangsläufig die gewünschten vorgestanzten und abgegitterten Haftfolienabschnitte zu erzielen.

In weiterer Ausgestaltung der Erfindung ist wenigstens eine Kontrollstation vorgesehen, an der die Funktion der Transponder überprüft wird. Zusätzlich kann es vorteilhaft vorgesehen sein, eine Kennzeichnungsstation vorzusehen, um die Transponder, bei denen eine Fehlfunktion festgestellt worden war, markieren zu können.

In weiterer Ausgestaltung der Erfindung ist eine Verbundstation vorgesehen, an der die Antennenfolienbahn einschließlich der aufgebrachten Chipmodule und Haftfolienabschnitte auf eine Rolle aufgewickelt wird. Diese Verbundrolle bildet eine kompakte Speicherrolle für die fertiggestellten elektronischen Folienbauteile.

In weiterer Ausgestaltung der Erfindung weist die Übergabestation eine Trenneinheit zum Vereinzeln der Chipmodule sowie eine Wendestation zum Übergeben der Chipmodule an die Haftfolienbahn mit der jeweiligen Rückseite auf. Dadurch werden die Chipmodule bereits in der Position vorgelegt, in der sie anschließend auf die Antennenfolienbahn aufgebracht werden müssen.

In weiterer Ausgestaltung der Erfindung ist eine Trennstation zur Unterteilung der mit den Chipmodulen versehenen Haftfolienbahn in separate Haftfolienabschnitte vorgesehen.

In weiterer Ausgestaltung der Erfindung ist eine Klebestation vorgesehen, an der ein Klebemittel auf die Antennenfolienbahn oder auf die Schutzfolienbahn aufgebracht wird. Vorteilhaft ist die Klebestation in Bahnförderrichtung vor der Haft- und Kontaktierungsstation der Chipmodule angeordnet. Zusätzlich vorteilhaft steuert die Klebstation einen Klebemittelauftrag derart, dass lediglich im Bereich der Chipmodule auf der Antennenfolienbahn oder der Schutzfolienbahn entsprechende Klebeflächen geschaffen werden. Dies unterstützt die Selbstklebeeigenschaften der Folienbahnen und verbessert somit eine lagegenaue Fixierung der Chipmodule. Durch den lediglich partiellen Klebemittelauftrag wird Klebemittel eingespart und ein störendes Verkleben bzw. Verschmutzen von Bereichen, die keinen Klebemittelauftrag benötigen, vermieden.

In weiterer Ausgestaltung der Erfindung ist eine Trägerfolienstation vorgesehen, an der die Trägerlage in Folienform in aufgewickeltem Zustand vorgelegt ist.

In weiterer Ausgestaltung der Erfindung ist eine Deckfolienstation vorgesehen, an der die Decklage in Folienform in aufgewickeltem Zustand vorgelegt ist.

In weiterer Ausgestaltung der Erfindung ist eine Klebestation vorgesehen, an der ein Klebemittel auf die Decklage und/oder auf die Trägerlage aufgebracht wird.

Das erfindungsgemäße elektronische Folienbauteil ist durch das oben beschriebene, erfindungsgemäße Verfahren herstellbar.

Weitere Vorteile und Merkmale der Erfindung ergeben sich aus den Ansprüchen sowie aus der nachfolgenden Beschreibung bevorzugter Ausführungsbeispiele der Erfindung, die anhand der Zeichnungen dargestellt sind.
- Fig. 1: zeigt schematisch in vergrößerter Schnittdarstellung ein elekt- ronisches Folienbauteil in Form eines Transponders, das mit- tels einer Vorrichtung gemäß Fig. 2 hergestellt worden ist,
- Fig. 2: eine Ausführungsform einer Vorrichtung zum kontinuierlichen Herstellen elektronischer Folienbauteile gemäß Fig. 1,
- Fig. 3: eine weitere Ausführungsform einer Vorrichtung zum kontinu- ierlichen Herstellen elektronischer Folienbauteile ohne Anten- nenstruktur gemäß Fig. 1,
- Fig. 4: schematisch in vergrößerter Schnittdarstellung ein weiteres e- lektronisches Folienbauteil in Form eines Transponders, das mittels einer Vorrichtung gemäß Fig. 7 hergestellt worden ist,
- Fig. 5: schematisch in vergrößerter Schnittdarstellung ein weiteres e- lektronisches Folienbauteil in Form eines Transponders,
- Fig. 6: schematisch in vergrößerter Schnittdarstellung ein weiteres e- lektronisches Folienbauteil in Form eines Transponders,
- Fig. 7: eine weitere Ausführungsform einer Vorrichtung zum kontinu- ierlichen Herstellen elektronischer Folienbauteile gemäß Fig. 4,
- Fig. 8: eine weitere Ausführungsform einer Vorrichtung zum kontinu- ierlichen Herstellen elektronischer Folienbauteile ohne Anten- nenstruktur gemäß Fig. 1,
- Fig. 9: Chipmodule, deren Anschlusskontakte bearbeitet wurden, so- wie Haftfolienabschnitte, auf welche die bearbeiteten Chipmo- dule aufgebracht sind, jeweils in einer Draufsicht, und
- Fig. 10: ein Zwischenschichtelement, einen Antennenfolienabschnitt mit einer Antenne sowie das auf Antennenanschlüsse aufgebrach- ten Zwischenschichtelement.

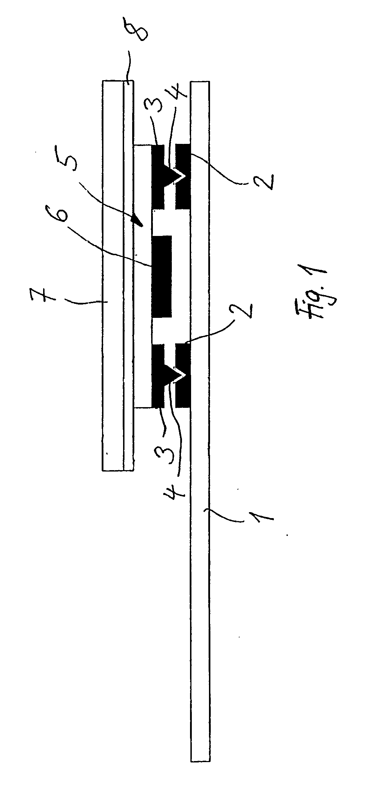

Ein elektronisches Folienbauteil gemäß Fig. 1 ist in Fig. 1 stark vergrößert und nicht maßstäblich dargestellt. Entgegen dem in Fig. 1 entstehenden Eindruck ist das Folienbauteil auch nicht steif oder formstabil, sondern vielmehr flexibel gestaltet. Das Folienbauteil gemäß Fig. 1 stellt vorzugsweise ein flexibles Folienetikett dar, das als Transponder ausgebildet ist. Hierzu ist auf einer unteren Trägerlage, die einen Antennenfolienabschnitt einer Antennenfolienbahn 1 darstellt, eine Antennenstruktur aufgedruckt, die zwei ebenfalls aufgedruckte Antennenanschlüsse 2 umfasst. Wie nachfolgend noch näher beschrieben werden wird, besteht die Antennenfolienbahn aus einer Vielzahl von hintereinander angeordneten Antennenfolienabschnitten, denen jeweils eine Antennenstruktur zugeordnet ist. Die Antennenfolienabschnitte schließen aneinander an und können durch Perforationen unterteilt sein. Alternativ ist es möglich, die verschiedenen Antennenfolienabschnitte nach der Fertigstellung der Folienbauteile durch geeignete Schneid- oder Stanzwerkzeuge voneinander zu trennen. Das Vorsehen von Perforationen ermöglicht das werkzeuglose Trennen der Antennenfolienabschnitte und damit das Vereinzeln der Folienbauteile. Die Antennenfolienbahn 1 trägt - wie nachfolgend näher beschrieben werden wird - eine Vielzahl von hintereinander auf der Antennenfolienbahn 1 angeordneten Folienbauteilen, die alle identisch zueinander ausgeführt sind. Zur Vereinfachung ist daher in Fig. 1 beispielhaft lediglich ein Folienbauteil dargestellt.

Jedes Folienbauteil weist ein Chipmodul 5 auf, das aus einem elektronischen Halbleiterbaustein 6 und einer Modulbrücke aufgebaut ist. Vorzugsweise ist der Halbleiterbaustein ein Mikrochip. Die entsprechende Modulbrücke dient zum Einen als Halterung für den Mikrochip. Zum Anderen schafft sie die elektrische Verbindung zu dem Mikrochip. Hierzu weist die Modulbrücke beidseitig des Mikrochips 6 jeweils einen elektrischen Anschlusskontakt 3 auf, der mit einem Kontaktpin oder einer Kontaktspitze 4 versehen ist, die zu der Antennenfolienbahn 1 nach unten abragen. Die elektrischen Anschlusskontakte 3 der Modulbrücke des Chipmoduls 5 sind derart auf die Antennenanschlüsse 2 abgestimmt, dass die Anschlusskontakte 3 exakt oberhalb der Antennenanschlüsse 2 positioniert sind und durch Eindringen der Kontaktspitzen 4 in die Antennenanschlüsse 2 elektrisch mit den Antennenanschlüssen 2 kontaktiert werden. Durch die elektrische Kontaktierung der Modulbrücke mit der Antennenstruktur wird der gewünschte Transponder geschaffen.

Jedes Chipmodul 5 ist an einer Klebeschicht 8 eines Haftfolienabschnittes 7 gehalten. Dabei ist die den Kontaktspitzen 4 gegenüberliegende Rückseite jedes Chipmoduls 5 mit dem Haftfolienabschnitt 7 verklebt. Die Grundfläche jedes Haftfolienabschnittes 7 ist wesentlich größer als eine Grundfläche jedes Chipmoduls 5, so dass der Haftfolienabschnitt 7 das Chipmodul 5 allseitig außen überlappt. Da auch der überlappende Bereich des Haftfolienabschnittes 7 auf seiner der Antennenfolienbahn 1 zugewandten Innenseite durchgängig mit der Klebeschicht 8 versehen ist, kann jeder Haftfolienabschnitt 7 um das Chipmodul 5 herum mit der Oberseite der Antennenfolienbahn 1 flächig verklebt werden. Hierdurch wird das Chipmodul 5 in seiner Position auf der Antennenfolienbahn 1 gesichert. Gleichzeitig wird auch die elektrische Kontaktierung der Kontaktspitzen 4 mit den Antennenanschlüssen 2 fixiert. Das Chipmodul 5 wie auch die aufgedruckten Antennenanschlüsse 2 der Antennenstruktur haben gemeinsam eine Höhe von weniger als 1 mm, so dass das geschaffene Folienetikett auch im Bereich des Chipmoduls 5 allenfalls geringfügig aufträgt oder geringfügig gegenüber der übrigen Etikettoberfläche erhaben ist.

Vorzugsweise wird die Klebeschicht 8 durch einen UV-aushärtenden Klebstoff dargestellt. Eine bevorzugte Schichtdicke beträgt 20 µm. Die Haftfolienbahn und damit auch der Haftfolienabschnitt 7 bestehen vorzugsweise aus einer Polyethylen-Trägerfolie, die vorzugsweise transparent oder opak gestaltet ist. Eine bevorzugte Schichtdicke der Haftfolienbahn 7 ist 50 µm. Jedes Chipmodul weist vorzugsweise eine Gesamtdicke von ca. 70 µm auf. Die Dicke der Antennenanschlüsse beträgt ca. 30 µm. Die Dicke der Antennenfolienbahn 1 beträgt ca. 70 µm. Vorzugsweise sind die Modulbrücken der Chipmodule 5 in einem Übergangsbereich entsprechender Antennenstrukturen mit einer Isolierschicht versehen, um Kurzschlüsse der Antennenbahnen zu vermeiden.

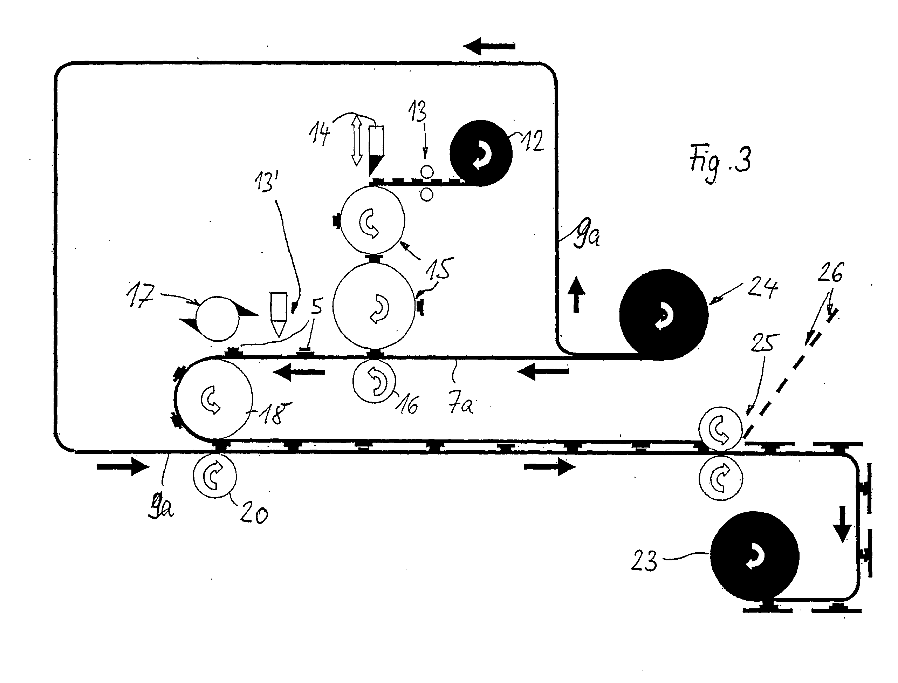

Das Chipmodul kann auch auf eine mit einer vorzugsweise aufgedruckten Antennenstruktur versehene Oberfläche eines Verpackungsmittels aufgebracht werden. Hierzu wird ein Chipmoduletikett mit der Vorrichtung gemäß Fig. 3 hergestellt.

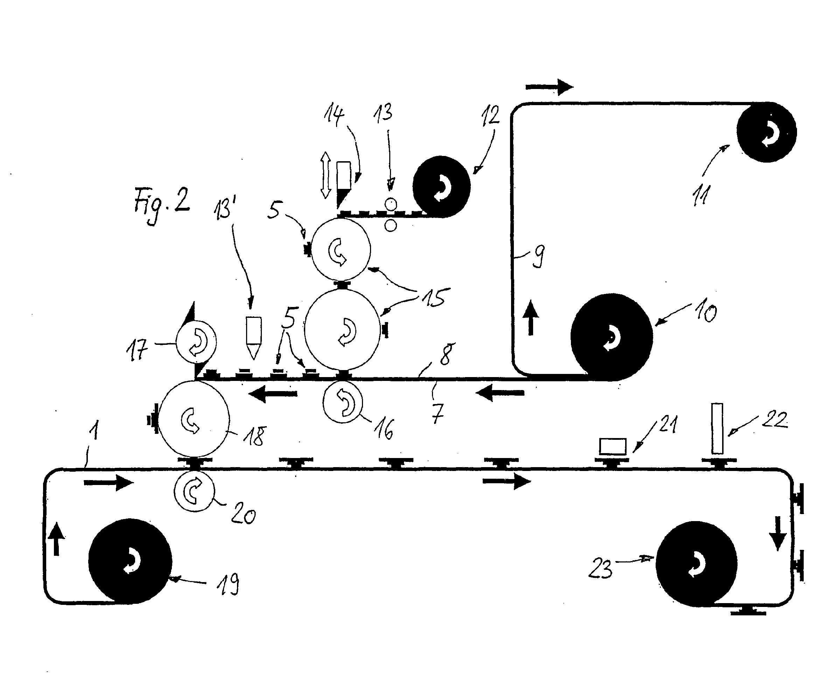

Zur Herstellung der beschriebenen elektronischen Folienbauteile ist gemäß Fig. 2 eine Maschine vorgesehen, die im Rolle/Rolle-Verfahren kontinuierlich arbeitet. Die in Fig. 2 schematisch gezeigte Maschine stellt eine Vorrichtung zum Herstellen elektronischer Folienbauteile im Sinne der Erfindung dar. Die Maschine gemäß Fig. 2 weist eine Haftfolienstation 10 auf, auf der die Haftfolienbahn 7, die innenseitig mit der Klebeschicht 8 versehen ist, auf eine Rolle aufgewickelt ist. Der Klebeschicht 8 der Folienbahn ist zusätzlich eine Schutzfolienbahn 9 zugeordnet, die bei dem dargestellten Ausführungsbeispiel durch eine Silikonträgerfolie gebildet ist. Die Haftfolienbahn 7 wird von der Rolle so abgewickelt, dass die Klebeschicht 8 oberseitig positioniert ist. Um die Klebeschicht 8 freizulegen, wird die Schutzfolienbahn 9 abgezogen und auf eine Trägerrolle 11 aufgewickelt.

Die Haftfolienbahn 7 durchläuft gemeinsam mit ihrer Klebeschicht 8 eine Übergabestation 14, 15, 16, an der die Chipmodule 5 vereinzelt und mit ihrer den Kontaktspitzen 4 abgewandten Rückseite auf die Klebeschicht 8 aufgebracht werden. Die Übergabestation 14, 15, an der die Kette aus Chipmodulen 5 vereinzelt wird und die vereinzelten Chipmodule auf die Haftfolienbahn 7, 7a aufgebracht werden, weist neben einer Trenneinrichtung 14 eine mit zwei gegenläufigen Umlenkrollen versehene Wendestation 15 auf. Die Chipmodule 5 sind an einer Chipmodulstation 12 in einer Reihe aneinanderhängend auf einer Speicherrolle aufgewickelt. Beim Abziehen der so gebildeten Kette aus Chipmodulen 5 werden die Anschlusskontakte 3 jedes Chipmoduls 5 an einer Kontaktvorbereitungsstation oder Prägestation 13 mit den Kontaktspitzen 4 versehen. Anschließend wird die Chipmodulkette an der Trennstation 14, die vorzugsweise als Schneidwerkzeug gestaltet ist, in die Chipmodule 5 vereinzelt. Die einzelnen Chipmodule 5 werden zunächst von einer gemäß der Darstellung nach Fig. 2 im Gegenuhrzeigersinn laufenden Umlenkrolle mitgenommen, wobei die Chipmodule 5 an einem Außenmantel der Umlenkrolle haften. Anschließend werden die Chipmodule 5 einer weiteren, gegensinnig und damit im Uhrzeigersinn laufenden Umlenkrolle der Wendestation 15 übergeben, die sich unterhalb der oberen Umlenkrolle befindet. Die Übergabe jedes Chipmoduls 5 von der oberen zur unteren Umlenkrolle erfolgt in einem Tangentialebenenbereich zwischen den beiden Umlenkrollen. Auch die untere Umlenkrolle ist an ihrem Außenumfang mit Haftmitteln, vorzugsweise Vakuumbohrungen von Saugmitteln, versehen, um die Chipmodule 5 am Außenumfang in Umfangsrichtung transportieren zu können. Durch die Übergabe der Chipmodule 5 von der oberen zur unteren Umlenkrolle liegen die Chipmodule 5 nunmehr nicht mit ihrer Rückseite, sondern mit ihrer die Kontaktspitzen aufweisenden Vorderseite an dem Außenmantel der unteren Umlenkrolle der Wendestation 15 an. Die Umfangsgeschwindigkeit der unteren Umlenkrolle ist derart auf die Bandlaufgeschwindigkeit der Haftfolienbahn 7 abgestimmt, dass die Chipmodule 5 in gleichmäßigen Abständen auf die Haftfolienbahn 7 aufgebracht und auf der Klebeschicht 8 fixiert werden. Die Wendestation weist unterhalb der Haftfolienbahn 7 eine Stützrolle 16 auf, die die Haftfolienbahn 7 in Abzugsrichtung fördert und gleichzeitig eine Gegenstütze für das Aufsetzen der Chipmodule 5 auf die Haftfolienbahn 7 bildet.

Die mit den Chipmodulen 5 bestückte Haftfolienbahn 7 wird zu einer kontinuierlich arbeitenden Trenneinrichtung transportiert, die als rotierendes Schneidwerkzeug 17 ausgeführt ist.

Alternativ zu der Prägestation 13 ist es möglich, erst nach dem Aufbringen der Chipmodule 5 auf die Haftfolienbahn 7 die Kontaktspitzen 4 der elektrischen Anschlusskontakte 3 der Chipmodule 5 zu bilden. Hierzu ist die Dosierstation 13' vorgesehen, die eine entsprechende Kontaktspitzenherstellung bewirkt.

Bei beiden Varianten zur Kontaktspitzengestaltung wird die Haftfolienbahn 7 mit den aufgebrachten Chipmodulen 5 zu mehreren Haftfolienabschnitten vereinzelt, die jeweils ein Chipmodul 5 tragen. Diese werden mittels einer Umlenkrolle 18 umgelenkt und an einer Haft- und Kontaktierungsstation 18, 20 auf die Antennenfolienbahn 1 aufgebracht. Die Antennenfolienbahn 1 ist an einer Antennenfolienstation auf einer Speicherrolle in aufgewickeltem Zustand gehalten und wird kontinuierlich von der Speicherrolle 19 abgezogen. Die Antennenfolienbahn weist eine Vielzahl von in einer Reihe hintereinander angeordneten Antennenfolienabschnitten auf, denen jeweils eine mit Antennenanschlüssen 2 versehene Antennenstruktur zugeordnet ist. Wie bereits beschrieben, ist die Antennenstruktur auf die Antennenfolienbahn 1 aufgedruckt oder alternativ aufgeätzt. Die Antennenstrukturen sind in gleichmäßigen Abständen zueinander auf der Antennenfolienbahn angeordnet. An der Kontaktierungs- und Haftstation 18, 20 werden die Haftfolienabschnitte einschließlich der Chipmodule 5 derart in gleichmäßigen Abständen kontinuierlich auf die Antennenfolienabschnitte aufgebracht, dass die Kontaktspitzen jedes Chipmoduls 5 jeweils exakt auf die Antennenanschlüsse 2 jeder Antennenstruktur auftreffen. Die Haftfolienabschnitte einschließlich der Chipmodule werden kontinuierlich auf die gleichmäßig vorbeilaufende Antennenfolienbahn 1 aufgedrückt, wodurch die Kontaktspitzen 4 sich unter Schaffung der entsprechenden elektrischen Kontaktierung keilartig in die Antennenanschlüsse 2 der Antennenstruktur einschneiden. Dadurch werden die Transponder geschaffen. Gleichzeitig sind die entsprechenden Umlenk- und Andrückrollen der Haft- und Kontaktierungsstation 18, 20, die von beiden Seiten her auf die Haftfolienabschnitte und die Antennenfolienbahn 1 wirken, derart nachgiebig ausgeführt, dass mit dem Eindrücken der Chipmodule auch die Haftfolienabschnitte mit ihrer entsprechenden Klebeschicht 8 auf die Oberseite jedes Antennenfolienabschnittes flächig aufgedrückt werden. Durch die Klebeschicht 8 erfolgt eine flächige Verklebung jedes Haftfolienabschnittes mit dem zugehörigen Antennenfolienabschnitt der Antennenfolienbahn 1, wodurch die elektrische Kontaktierung der Chipmodule 5 an den Antennenstrukturen gesichert wird. Die schematische Darstellung in Fig. 2 lässt nicht erkennen, dass die Haftfolienabschnitte nach dem Durchlaufen der Haft- und Kontaktierungsstation 18, 20 flächig mit der Antennenfolienbahn verbunden sind. Die so gebildeten, fertigen Folienbauteile werden auf der Antennenfolienbahn 1 weitergefördert und durchlaufen eine Kontrollstation 21, in der die elektrische und/oder elektronische Funktion der Transponder überprüft wird. Anschließend durchläuft die aneinandergeschlossene Reihe oder Kette von Transpondern noch eine Kennzeichnungsstation 22, an der eine Kennzeichnung der Folienbauteile im Hinblick auf eine etwa festgestellte Fehlfunktion, insbesondere durch einen Tintenstrahldruck, vorgenommen wird. Schließlich wird die Kette von Folienbauteilen auf eine Speicherrolle einer Verbundstation 23 aufgewickelt, die für eine Lagerung oder einen weiteren Transport der Folienbauteile geeignet ist. ,

Beim Ausführungsbeispiel nach Fig. 3 sind alle funktionsgleichen Einheiten, Bauteile und Bahnen mit identischen Bezugszeichen wie in Fig. 2 versehen. Lediglich die funktionsgleiche Haftfolienbahn ist ergänzend noch mit dem Buchstaben "a" versehen. Wesentlicher Unterschied ist es, dass hier selbstklebende Chipmoduletiketten ohne Transponderfunktion, d.h. ohne Antennenstruktur, hergestellt werden. Erst in einem späteren, hier nicht dargestellten Prozess werden diese Chipmoduletiketten auf Oberflächen, insbesondere von Verpackungsmitteln, aufgebracht, die mit einer entsprechenden Antennenstruktur versehen sind.

Bei der Ausführungsform nach Fig. 3 wird die Schutzfolienbahn als Trägerlage für die hergestellten Chipmoduletiketten wieder verwendet. Die Haftfolienbahn 7a und die Schutzfolienbahn 9a sind in einem Selbstklebeverbund auf einer Vorlagerolle einer Vorlagestation 24 aufgewickelt. Zum Freilegen der nicht näher bezeichneten Klebeschicht 8 der Haftfolienbahn 7a wird die Schutzfolienbahn 9a unmittelbar nach dem Abwickeln von der Vorlagerolle der Vorlagestation 24 abgezogen, oberhalb der Chipmodulstation um die Anlage herumgeführt und im Bereich der Haft- und Kontaktierungsstation 18, 20 als Trägerlage wieder zugeführt. Die Haft- und Kontaktierungsstation dient bei dieser Ausführungsform ausschließlich dazu, die Chipmodule auf die Schutzfolienbahn 9a aufzubringen, ohne dass eine zusätzliche elektrische Kontaktierungsfunktion -mangels Anschlüssen einer Antennenfolienbahn- erfolgt.

Die Wendestation 15 zum Aufbringen der Chipmodule 5 auf die Haftfolienbahn 7a ist identisch zu der Ausführungsform nach Fig. 2 ausgeführt, so dass hierauf an dieser Stelle nicht näher eingegangen werden muss. Ein weiterer Unterschied der Ausführungsform nach Fig. 3 ist es, dass die Trenneinrichtung in Form des rotatorisch arbeitenden Schneidwerkzeuges 17 bei dieser Ausführungsform außer Kraft gesetzt ist. Denn die Haftfolienbahn 7a wird vor der Haft- und Kontaktierungsstation 18, 20 nicht in einzelne Haftfolienabschnitte unterteilt. Vielmehr bleibt die Haftfolienbahn 7a mit den aufgebrachten Chipmodulen 5 als Einheit erhalten und wird um die entsprechende Umlenkrolle der Haft- und Kontaktierungsstation 18, 20 so umgelenkt, dass die Haftfolienbahn 7a mit gleicher Bandgeschwindigkeit wie die Schutzfolienbahn 9a in gleicher Richtung parallel gefördert wird. Die Chipmodule 5 sind auf die Haftfolienbahn 7a in gleichmäßigen Abständen zueinander aufgebracht, um später als Chipmoduletiketten von der als Silikonträgerfolie ausgeführten Schutzfolienbahn abgezogen werden zu können. Zudem wird die Haftfolienbahn 7a der Schutzfolienbahn 9a im Bereich der Haft- und Kontaktierungsstation 18, 20 so zugeführt, dass die Chipmodule mit ihren Kontaktspitzen auf der Schutzfolienbahn zur Auflage kommen. Gleichzeitig wird die gesamte Haftfolienbahn 7a um die Chipmodule 5 herum flächig auf die Schutzfolienbahn 9a aufgeklebt, so dass sich eine Verbundfolienbahn ergibt. In Förderrichtung abwärts gelegen zu der Haft- und Kontaktierungsstation 18 ist eine Trennstation 25 vorgesehen, die mittels eines rotatorisch arbeitenden Stanzwerkzeugs die Haftfolienabschnitte der Haftfolienbahn 7a ausstanzt und das verbleibende Stanzabfallgitter 26 nach oben abzieht. Die Schutzfolienbahn 9a wird durch das Stanzwerkzeug nicht beeinträchtigt. Auf der Schutzfolienbahn 9a verbleiben nun die Haftfolienabschnitte mit den Chipmodulen, wobei die Haftfolienabschnitte eine gegenüber der Haftfolienbahn 7a reduzierte Breite aufweisen, um ein kontinuierliches, endloses Abziehen des Stanzabfallgitters der Haftfolienbahn 7a zu erzielen. Dadurch werden die abgegitterten Chipmoduletiketten geschaffen, die auf der Schutzfolienbahn gehalten sind. Die nun fertiggestellten Folienbauteile (Chipmoduletiketten) werden einschließlich der Schutzfolienbahn 9a auf eine Speicherrolle der Verbundstation 23 aufgewickelt. Die so gebildete Speicherrolle umfasst eine Vielzahl von aneinanderhängenden Folienbauteilen in Form der Chipmoduletiketten ohne Transponderfunktion.

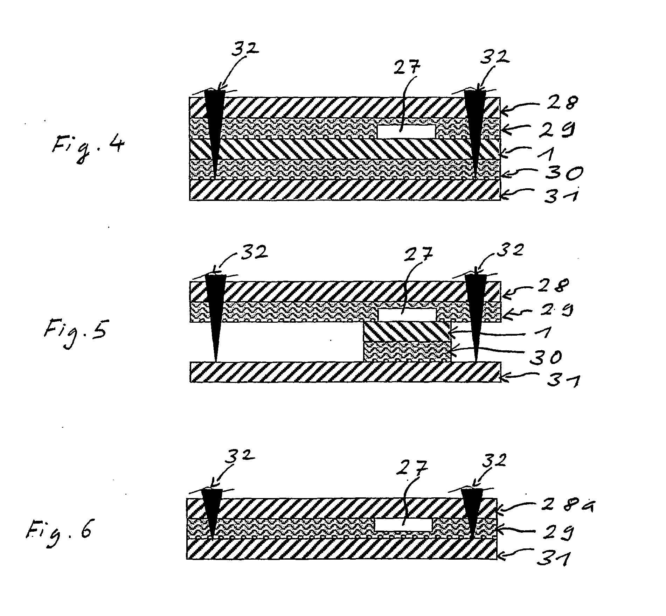

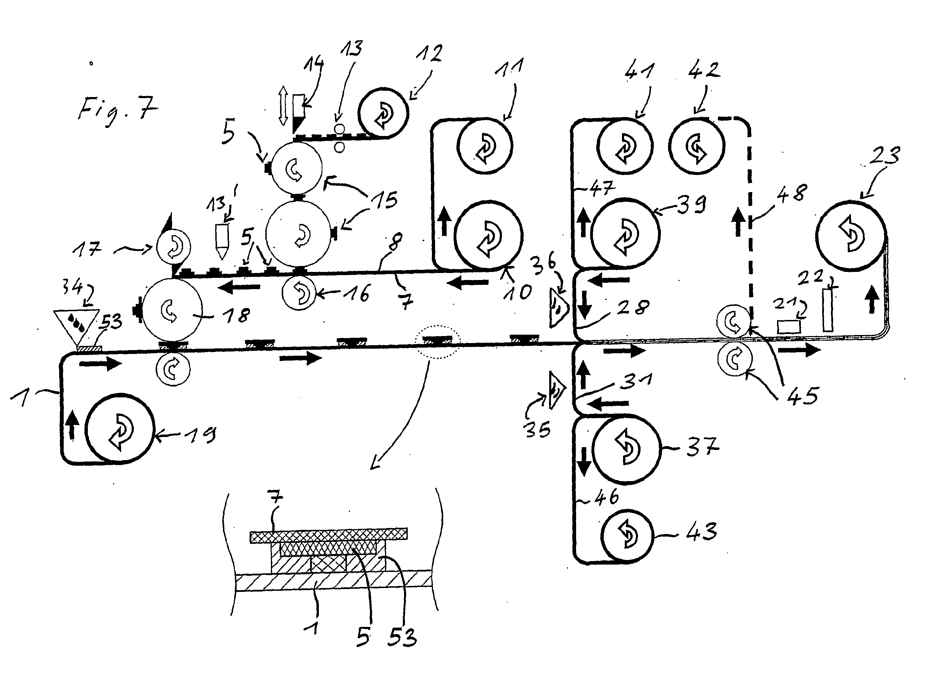

Fig. 4 zeigt stark vergrößert und nicht maßstäblich in Schnittdarstellung ein weiteres elektronisches Folienbauteil in Form eines Transponders, das mittels einer Vorrichtung gemäß Fig. 7 herstellbar ist. Die in Fig. 1 gezeigte Kombination aus Chipmodul 5, Klebstoff 8 und Haftfolienabschnitt 7 ist zu einem Zwischenschichtelement 27 zusammengefasst. Beim Ausführungsbeispiel nach Fig. 4 sind alle weiteren, funktionsgleichen Elemente mit identischen Bezugszeichen wie in Fig. 1 versehen. Das Zwischenschichtelement 27 ist, wie in Fig. 1 gezeigt, mit Antennenanschlüssen 2 einer Antenne eines Antennenfolienabschnitts der Antennenfolienbahn 1 elektrisch kontaktiert und relativ zu den Antennenanschlüssen 2 lagefixiert. Zusätzlich sind im Vergleich zu dem in Fig. 1 gezeigten Folienbauteil eine Trägerlage 31 aus Silikon und eine Decklage 28 vorgesehen, die mit Hilfe von Klebemittelschichten 29 und 30 stoffschlüssig mit einer Oberseite der Antennenfolienbahn 1 und dem Zwischenschichtelement 27 bzw. einer Unterseite der Antennenfolienbahn 1 verbunden sind.

Zur Trennung der verschiedenen Antennenfolienabschnitte nach der Fertigstellung der Folienbauteile dient ein Stanzmesser 32, mit dem bei einem Stanzvorgang alle Lagen bzw. Schichten bis auf die Trägerlage 31 durchtrennt werden. Nach dem Stanzvorgang kann somit das Folienbauteil von der Trägerlage 31 abgezogen werden, wobei die Klebemittelschicht 30 an dem abgezogenen Formteil verbleibt, wodurch dieses selbstklebend, beispielsweise auf einer Verpackung angebracht werden kann.

Fig. 5 zeigt eine alternative Ausführungsform eines elektronischen Folienbauteils in Form eines Transponders, das im Vergleich zu der in Fig. 4 gezeigten Ausführungsform eine verkürzte Antennenfolienbahn 1 bzw. einen verkürzten Antennenfolienabschnitt und, daran angepasst, eine verkürzte Klebemittelschicht 30 aufweist. Funktionsgleiche Elemente sind wiederum mit identischen Bezugszeichen versehen.

Fig. 6 zeigt eine weitere alternative Ausführungsform eines elektronischen Folienbauteils in Form eines Transponders, das im Vergleich zu den in Fig. 4 und Fig. 5 gezeigten Ausführungsformen zwei Lagen bzw. Schichten weniger aufweist. Funktionsgleiche Elemente sind wiederum mit identischen Bezugszeichen versehen. Auf einer dem Zwischenschichtelement 27 der Decklage 28a zugewandten Seite der Decklage 28a ist eine nicht gezeigte Antenne aufgebracht, die wiederum elektrisch mit dem Zwischenschichtelement 27 in Kontakt steht. Durch die Kombination von Antennen- und Decklage können folglich 2 Schichten eingespart werden.

Fig. 7 zeigt eine weitere Ausführungsform einer Vorrichtung zum kontinuierlichen Herstellen elektronischer Folienbauteile gemäß Fig. 4. Die Vorrichtung weist zusätzlich zu der in Fig. 2 gezeigten Vorrichtung erste bis dritte Klebestationen 34 bis 36, eine Trägerfolienstation 37, an der die bahnförmige Trägerlage 31 in Folienform in aufgewickeltem Zustand vorgelegt ist, eine Deckfolienstation 39, an der die bahnförmige Decklage 28 in Folienform in aufgewickeltem Zustand vorgelegt ist, Sammelrollen 41 bis 43 und eine Stanzstation 45 auf. Beim Ausführungsbeispiel nach Fig. 7 sind alle weiteren, funktionsgleichen Elemente mit identischen Bezugszeichen wie in Fig. 2 versehen.

Durch die erste Klebestation 34 wird vor dem elektrischen Kontaktieren und vor dem Verbinden der Haftfolienabschnitte 7 mit den Antennenfolienabschnitten durch die Haft- und Kontaktierungsstation 18, 20 ein Klebemittel 53 derart auf die Antennenfolienabschnitte aufgebracht, dass sich nach dem elektrischen Kontaktieren und dem Verbinden eine Klebemittelschicht zwischen den Haftfolienabschnitten 7 und den Chipmodulen 5 einerseits und den Antennenfolienabschnitten bzw. der Antennenfolienbahn 1 andererseits bildet, deren minimale Ausdehnung durch die Grenzflächen zwischen den Chipmodulen 5 und den Antennenfolienabschnitten festgelegt wird und deren maximale Ausdehnung durch die Grenzflächen zwischen den Haftfolienabschnitten 7 und den Antennenfolienabschnitten festgelegt wird. Der Klebemittelauftrag erfolgt folglich nicht kontinuierlich, sondern derart getaktet, dass sich die gewünschte örtliche Klebemittelverteilung einstellt. Der durch die erste Klebestation 34 bewirkte Klebemittelauftrag unterstützt die Selbstklebeeigenschaften der Haftfolienabschnitte 7, wodurch sich eine Verbesserung der Klebekraft und somit eine sicherere Fixierung der Chipmodule 5 relativ zu den Antennenanschlüssen 2 ergibt.

Durch die Trägerfolienstation 37 wird die bahnförmige Trägerlage 31 der zweiten Klebestation 35 zugeführt und dort mit der in Fig. 4 gezeigten Klebemittelschicht 30 versehen. Anschließend wird die mit der Klebemittelschicht 30 versehene Trägerlage 31 mit der Unterseite der Antennenfolienbahn 1 verbunden, wobei durch die Klebemittelschicht 30 eine stoffschlüssige Verbindung zwischen der Antennenfolienbahn 1 und der Trägerlage 31 entsteht. Zum Schutz der Trägerlage 31 ist diese in der Trägerfolienstation 37 zusammen mit einer Schutzfolie bzw. Schutzlage 46 aufgewickelt, die während des Zuführens von der Trägerlage 31 abgezogen und auf die Sammelrolle 43 aufgewickelt wird.

Durch die Deckfolienstation 39 wird die bahnförmige Decklage 28 der dritten Klebestation 36 zugeführt und dort mit der in Fig. 4 gezeigten Klebemittelschicht 29 versehen. Anschließend wird die mit der Klebemittelschicht 29 versehene Decklage 28 mit der Oberseite der Antennenfolienbahn 1 und dem Zwischenschichtelement 27 verbunden, wobei durch die Klebemittelschicht 29 eine stoffschlüssige Verbindung entsteht. Zum Schutz der Decklage 28 ist diese in der Deckfolienstation 39 zusammen mit einer Schutzfolie bzw. Schutzlage 47 aufgewickelt, die während des Zuführens von der Decklage 28 abgezogen und auf die Sammelrolle 41 aufgewickelt wird.

Die Klebestationen 35 und 36 sind optional. Wenn die Decklage 28 und/oder die Trägerlage 31 als selbstklebende Lagen ausgeführt sind, befindet sich die zugehörige Klebemittelschicht 29 bzw. 30, geschützt durch die Schutzfolie bzw. Schutzlage 46 bzw. 47, bereits dann auf der Decklage 28 bzw. der Trägerlage 31, wenn diese auf ihrer zugehörigen Folienstation 37 bzw. 39 aufgewickelt ist. Ein zusätzlicher Klebemittelauftrag durch die Klebestationen 35 und 36 ist in diesem Fall folglich nicht mehr notwendig.

Nachdem sowohl die Trägerlage 31 als auch die Decklage 28 aufgebracht worden sind, wird der entstandene Lagen- bzw. Schichtenverbund der Stanzstation 45 zugeführt, die mittels der in Fig. 4 gezeigten Stanzmesser 32 alle Lagen bis auf die Trägerlage 31 trennt. Ein entstehendes Stanzabfallgitter 48 wird nach oben abgezogen und auf die Sammelrolle 42 aufgewickelt. Der verbleibende Lagenverbund, d.h. die fertiggestellten Folienbauteile bzw. Transponder, wird auf die Speicherrolle der Verbundstation 23 aufgewickelt, die für eine Lagerung oder einen weiteren Transport der Folienbauteile geeignet ist.

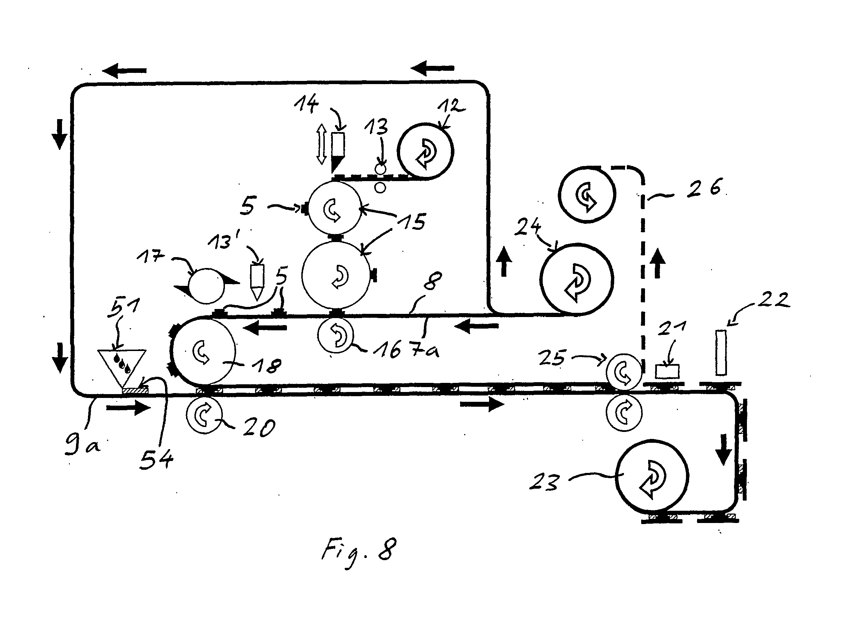

Fig. 8 zeigt eine weitere Ausführungsform einer Vorrichtung zum kontinuierlichen Herstellen elektronischer Folienbauteile ohne Antennenstruktur. Die Vorrichtung weist zusätzlich zu der in Fig. 3 gezeigten Vorrichtung eine Klebestation 51 auf. Beim Ausführungsbeispiel nach Fig. 8 sind alle weiteren, funktionsgleichen Elemente mit identischen Bezugszeichen wie in Fig. 3 versehen. Durch die Klebestation 51 wird vor dem Zusammenführen der Haftfolienbahn 7a und der Schutzfolienbahn 9a im Bereich der Haft- und Kontaktierungsstation 18, 20 ein Klebemittel 54 derart auf die Schutzfolienbahn 9a aufgebracht, dass sich nach dem Zusammenführen der Bahnen 7a und 9a eine Klebemittelschicht im Bereich der Chipmodule 5 bildet. Der Klebemittelauftrag erfolgt nicht kontinuierlich, sondern derart getaktet, dass sich die gewünschte örtliche Klebemittelverteilung einstellt. Der durch die Klebestation 51 bewirkte Klebemittelauftrag unterstützt die Selbstklebeeigenschaften der Schutzfolienbahn 9a, wodurch sich eine Verbesserung der Klebekraft ergibt.

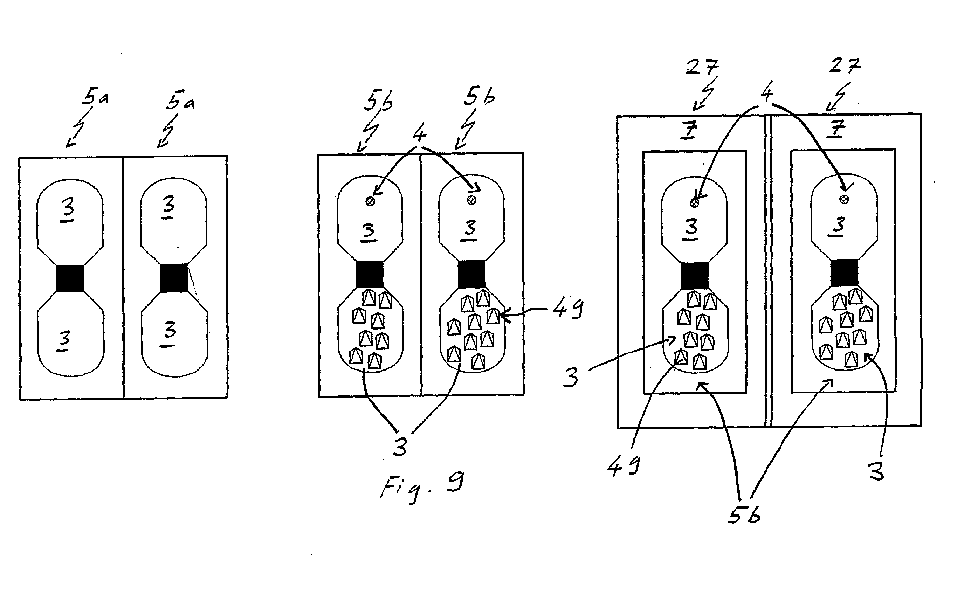

Fig. 9 zeigt, jeweils in einer Draufsicht, unbearbeitete Chipmodule 5a, bearbeitete Chipmodule 5b, deren Anschlusskontakte 3 bearbeitet wurden, sowie Haftfolienabschnitte 7, auf welche die bearbeiteten Chipmodule 5b aufgebracht bzw. aufgeklebt sind. Die unbearbeiteten Chipmodule 5a sind beispielsweise an der Chipmodulstation 12 von Fig. 2 in einer Reihe aneinanderhängend auf deren Speicherrolle aufgewickelt.

Die oberen Anschlusskontakte 3 der Chipmodule 5b sind exemplarisch mit Kontaktspitzen 4 versehen, die beispielsweise durch die Kontaktvorbereitungsstation oder Prägestation 13 von Fig. 2 erzeugt werden können. Die unteren Anschlusskontakte 3 der Chipmodule 5b sind alternativ mit im wesentlichen pyramidenförmigen, harten und leitfähigen Partikeln 49 versehen, die derart ausgerichtet sind, dass Spitzen der Pyramiden 49 in Richtung des korrespondierenden Anschlusses, d.h. des Antennenanschlusses, zeigen. Eine großflächige Unterseite eines Partikels 49 liegt idealerweise vollflächig auf dem Anschlusskontakt 3 auf. Aus Gründen der einfacheren Darstellung sind jeweils lediglich wenige Partikel bzw. Pyramiden 49 pro Anschlusskontakt 3 gezeichnet. Tatsächlich sind jedoch viele, beispielsweise mehrere hundert derartige Partikel 49 pro Anschlusskontakt 3 vorhanden. Die Partikel 49 können beispielsweise aus Diamantstaub bestehen, der mit Nickel überzogen ist. Die Größe der Partikel liegt dabei typischerweise bei 4µum bis 25µum. Wenn während eines Kontaktierungsvorgangs auf der flächigen Unterseite ein geringer Druck aufgebaut wird, so ergibt sich daraus an der Spitze des Partikels 49 eine Druckerhöhung proportional dem Verhältnis der Flächen zueinander. Wenn die Spitze des Partikels 49 auf den korrespondierenden Anschluss drückt, dringt diese in das sich verformende Material des Verbindungspartners ein und erzeugt somit eine leitende elektrische Verbindung. Das Aufbringen der Partikel 49 erfolgt typischerweise bereits bei der Herstellung der Chipmodule 5.

In Fig. 9 rechts sind Haftfolienabschnitte 7 abgebildet, auf welche die bearbeiteten Chipmodule 5b aufgebracht bzw. aufgeklebt sind. Die Chipmodule 5b, eine nicht gezeigte Klebstoffschicht und die Haftfolienabschnitte 7 bilden zusammen jeweils ein Zwischenschichtelement 27 von Fig. 4. Das derart gebildete Zwischenschichtelement 27 lässt sich wesentlich einfacher mit den Antennenfolienabschnitten verbinden, als ein Chipmodul 5.

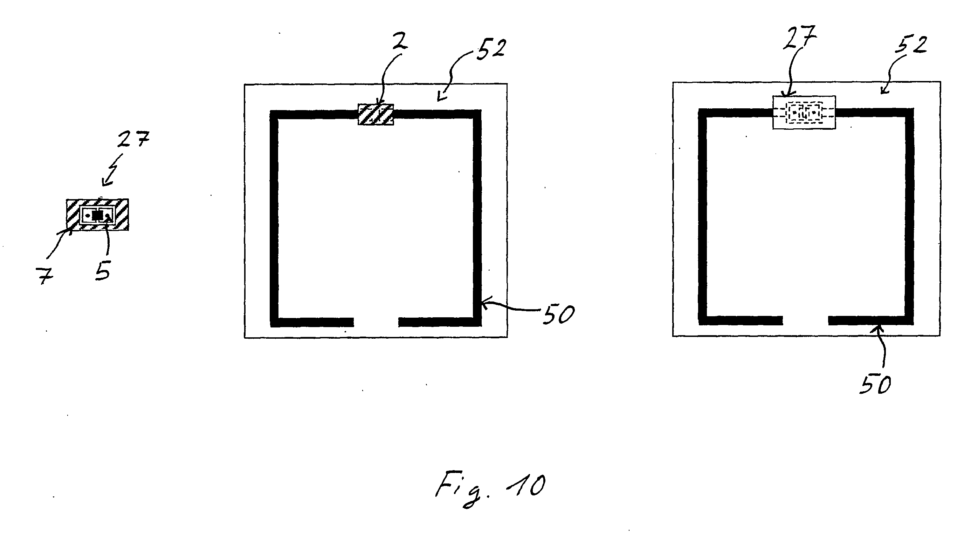

Fig. 10 zeigt, jeweils in einer Draufsicht, ein derartiges Zwischenschichtelement 27, einen Antennenfolienabschnitt 52 mit einer Antenne 50, die Antennenanschlüsse 2 aufweist, sowie das auf die Antennenanschlüsse 2 im Vergleich zur Darstellung links umgedreht aufgebrachte Zwischenschichtelement 27. Die Verbindung aus Zwischenschichtelement 27 und Antennenfolienabschnitt 52 stellt bereits einen funktionsfähigen Transponder dar, der nun lediglich, wie in Fig. 7 gezeigt, noch mit einer Träger- und einer Deckschicht versehen wird.

Um die erfindungsgemäßen Verfahren, wie anhand der Figuren 1 bis 3 beschrieben, automatisch und kontinuierlich in der Vorrichtung durchführen zu können, ist eine zentrale Steuereinheit vorgesehen, die die entsprechenden Stationen, Werkzeuge und Laufgeschwindigkeiten der Förder- und Umlenkrollen entsprechend ansteuert. Es ist auch möglich, durch entsprechende Sensorikeinheiten die maßgeblichen physikalischen Größen der einzelnen Funktions- und Vorrichtungseinheiten einschließlich Stationen, Werkzeugen, Förder- und Umlenkrollen zu überwachen und entsprechende Signal- oder Rückmeldungen an die Steuereinheit zu geben, wodurch eine Regelung des Verarbeitungs- und Herstellungsprozesses der Folienbauteile ermöglicht wird.

## Patentansprüche

1. Verfahren zum kontinuierlichen Herstellen elektronischer Folienbauteile, bei denen Chipmodule (5) mit ihren elektrischen Anschlusskontakten (3) auf Antennenanschlüsse (2) von Antennenfolienabschnitten (1), denen jeweils eine Antennenstruktur zugeordnet ist aufgebracht werden, wobei die Chipmodule (5) mit ihrer den Anschlusskontakten abgewandten Rückseite auf Haftfolienabschnitte (7) aufgebracht werden, deren Grundfläche jeweils wesentlich größer ist als eine Grundfläche des zugehörigen Chipmoduls (5), und die Haftfollenabschnitte (7) flächig mit den Antennenfolienabschnitten (1) verbunden werden,
**dadurch gekennzeichnet, dass** jeder Haftfolienabschnitt (7) auf seiner der Antennenfolienbahn (1) zugewandten Innenseite durchgängig mit einer Klebeschicht (8) versehen ist, so dass der Haftfolienabschnitt (7) um das zugehörige Chipmodul (5) herum mit der Antennenfolienbahn (1) flächig verklebt werden kann, wodurch die Chipmodule (5) relativ zu den Antennenanschlüssen (2) lagefixiert werden und der Kontakt zwischen den Chipmodulen (5) und den Antennenstrukturen gesichert wird.

2. Verfahren nach Anspruch 1, **dadurch gekennzeichnet, dass** zur Herstellung der Folienbauteile in Form von Transpondern die Chipmodule (5) auf Antennenfolienabschnitten einer Antennenfolienbahn aufgebracht werden.

3. Verfahren zum kontinuierlichen Herstellen elektronischer Folienbauteile nach Patentanspruch 1, **dadurch gekennzeichnet, dass** zur Herstellung der Folienbauteile elektrische Anschlusskontakte der Chipmodule mit Kontaktspitzen versehen werden, um jeweils in einem späteren Verfahrensschritt mit Antennenanschlüssen einer Antennenstruktur eines Antennenfolienabschnittes mechanisch in eine elektrisch leitfähige Verbindung gebracht zu werden, und dass der wenigstens eine Antennenfolienabschnitt Teil einer Oberfläche eines Verpackungsmittels ist.

4. Verfahren nach einem der Ansprüche 1 bis 3, **dadurch gekennzeichnet, dass** eine einseitig mit einer Haftschicht (8) versehene Haftfolienbahn (7) kontinuierlich in gleichmäßigen Abständen mit den Chipmodulen (5) bestückt wird, und dass anschließend die Haftfolienbahn (7, 7a) in einzelne Haftfollenabschnitte unterteilt wird, die jeweils ein Chipmodul (5) tragen.

5. Verfahren nach Anspruch 4, **dadurch gekennzeichnet, dass** die Unterteilung der Haftfolienbahn (7, 7a) in einzelne Haftfolienabschnitte zeitlich vor dem elektrischen Kontaktieren der Chipmodule (5) mit den Antennenanschlüssen (2) erfolgt.

6. Verfahren nach einem der vorhergehenden Ansprüche, **dadurch gekennzeichnet, dass** die Kontaktspitzen der elektrischen Anschlusskontakte (3, 4) der Chipmodule (5) mechanisch in die elektrisch leitfähigen Antennenanschlüsse eingedrückt werden.

7. Verfahren nach Anspruch 5, **dadurch gekennzeichnet, dass** die Haftfolienbahn (7, 7a) und eine Schutzfolienbahn (9a) flächig miteinander verbunden und in einer Verbundfolienbahn auf eine Rolle aufgewickelt werden, dass die Verbundfolienbahn von der Rolle abgewickelt wird, und dass die Haftfolienbahn (7a) und die Schutzfolienbahn (9a) vor dem Aufbringen der Chipmodule (5) voneinander abgezogen und unterschiedlichen Bahnverläufen zugeführt werden.

8. Verfahren nach Anspruch 2, **dadurch gekennzeichnet, dass** die mittels der Haftfollenabschnitte auf die Antennenfolienabschnitte der Antennenfolienbahn aufgebrachten Chipmodule (5) gemeinsam mit der Antennenfolienbahn auf eine Rolle aufgewickelt werden.

9. Verfahren nach Anspruch 3, **dadurch gekennzeichnet, dass** die auf die Haftfolienbahn aufgebrachten Chipmodule gemeinsam mit der Schutzfolienbahn auf eine Rolle aufgewickelt werden.

10. Verfahren nach Anspruch 8, **dadurch gekennzeichnet, dass** vor dem Aufwickeln der Chipmodule (5) gemeinsam mit der Antennenfolienbahn (1) die elektrische und/oder elektronische Funktion der Folienbauteile überprüft wird.

11. Verfahren nach einem der vorhergehenden Ansprüche, **dadurch gekennzeichnet, dass** die elektrischen Anschlusskontakte (3) der Chipmodule (5) und/oder die Antennenanschlüsse (2) mit im wesentlichen pyramidenförmigen, harten und leitfähigen Partikeln (49) versehen werden, die derart ausgerichtet sind, dass Spitzen der Pyramiden in Richtung des korrespondierenden Anschlusses zeigen.

12. Verfahren nach Anspruch 2, **dadurch gekennzeichnet, dass** vor dem elektrischen Kontaktieren der elektrischen Anschlusskontakte (3) der Chipmodule (5) mit den Antennenanschlüssen (2) und vor dem Verbinden der Haftfolienabschnitte (7, 8) mit den Antennenfolienabschnitten (1) ein Klebemittel derart auf die Antennenfolienabschnitte (1) aufgebracht wird, dass sich nach dem elektrischen Kontaktieren und dem Verbinden eine Klebemittelschicht bildet, deren minimale Ausdehnung durch die Grenzflächen zwischen den Chipmodulen (5) und den Antennenfolienabschnitten (1) festgelegt wird und deren maximale Ausdehnung durch die Grenzflächen zwischen den Haftfolienabschnitten (7, 8) und den Antennenfolienabschnitten (1) festgelegt wird.

13. Verfahren nach Anspruch 2, **dadurch gekennzeichnet, dass** nach dem elektrischen Kontaktieren der elektrischen Anschlusskontakte (3) der Chipmodule (5) mit den Antennenanschlüssen (2) und nach dem Verbinden der Haftfolienabschnitte (7, 8) mit den Antennenfolienabschnitten (1) auf den Antennenfolienabsohnitten (1) eine Trägerlage (31), Insbesondere eine Sillkonträgeriage, aufgebracht wird und/oder auf den Haftfollenabschnltten (7,8) eine Decklage (28) aufgebracht wird.

14. Vorrichtung zur Durchführung eines Verfahrens nach wenigstens einem der vorhergehenden Ansprüche mit einer Chipmodulstation (12), an der die Chipmodule (5) gespeichert sind, sowie mit einer Haftfolienstation (10, 24), an der die Haftfolienbahn (7, 7a) rollenförmig vorgelegt ist, wobei eine Übergabestation (15) vorgesehen ist, an der die Chipmodule (5) vereinzelt mit ihrer Rückseite auf die Haftflächenseite (8) der Haftfolienbahn (7, 7a) aufgebracht werden, und wobei die Abstände der Chipmodule (5) bei der Aufbringung auf die Haftfolienbahn derart groß gewählt sind, dass jeweils ein das zugehörige Chipmodul (5) umgebender Haftfolienabschnitt wesentlich großflächiger ist als die Grundfläche des jeweiligen Chipmoduls (5) und auf seiner der Antennenfolienbahn (1) zugewandten Innenseite durchgängig mit der Klebeschicht (8) versehen ist, und mit Mitteln zum flächigen Verkleben des Haftfolienabschnitts (7) mit der Oberseite der Antennenfollenbahn (1) um das Chipmodul (5) herum, um den Kontakt zwischen den Chipmodulen (5) und den Antennenstrukturen zu sichern.

15. Vorrichtung nach Anspruch 14. **dadurch gekennzeichnet, dass** eine Kontaktvorbereitungsstation (13, 13') vorgesehen ist, an der elektrische Anschlusekontakte der Chipmodule mit Kontaktspitzen versehen werden.

16. Vorrichtung nach Anspruch 14 oder 15, **dadurch gekennzeichnet, dass** eine Antennenfolienstation (19) vorgesehen ist, an der die Antennenfollenbahn (1) In aufgewickeltem Zustand vorgelegt ist.

17. Vorrichtung nach einem der Ansprüche 14 bis 16, **dadurch gekennzeichnet, dass** eine Kontaktierungsstation (18, 20) zum kontinuierlichen mechanischen Kontaktieren der elektrischen Anschlusskontakte der Chipmodule (6) mit Antennenenschlüssen (2) von Antennenfolienabschnitten der Antennenfolienbahn (1) vorgesehen ist.

18. Vorrichtung nach Anspruch 17, **dadurch gekennzeichnet, dass** eine Haftstation (18, 20) vorgesehen ist, an der über die Chipmodule (5) hinausragende Haftfolienabschnitte flächig mit den Antennenfolienabschnitten verbunden werden, auf denen das jeweilige Chipmodul (5) elektrisch kontaktiert ist.

19. Vorrichtung nach einem der Ansprüche 14 bis 16, **dadurch gekennzeichnet, dass** die Breite der Haftfolienbahn (7a) größer ist als die Breite der Haftfolienabschnitte.

20. Vorrichtung nach einem der Ansprüche 14 bis 19, **dadurch gekennzeichnet, dass** wenigstens eine Kontrollstation (21) vorgesehen ist, an der die Funktion der Transponder überprüft wird.

21. Vorrichtung nach einem der Ansprüche 14 bis 12, **dadurch gekennzeichnet, dass** eine Verbundstation (23) vorgesehen ist, an der die Antennenfolienbahn (1) einschließlich der aufgebrachten Chipmodule (5) und Haftfolienabschnitte auf eine Rolle aufgewickelt sind.

22. Vorrichtung nach einem der Ansprüche 14 bis 21, **dadurch gekennzeichnet, dass** die Übergabestation eine Trenneinheit (14) zum Vereinzeln der Chipmodule (5) sowie eine Wendestation (15) zum Übergeben der Chipmodule (5) mit der jeweiligen Rückseite an die Haftfolienbahn aufweist.

23. Vorrichtung nach einem der Ansprüche 14 bis 22, **dadurch gekennzeichnet, dass** eine Trennstation (25) zur Unterteilung der mit den Chipmodulen (5) versehenen Haftfolienbahn (7a) in separate Haftfolienabschnitte vorgesehen ist.

24. Vorrichtung nach einem der Ansprüche 14 bis 23, **dadurch gekennzeichnet, dass** eine Klebestation (34, 51) vorgesehen ist, an der ein Klebemittel (53, 54) auf die Antennenfolienbahn (1) oder auf die Schutzfolienbahn (9a) aufgebracht wird.

25. Vorrichtung nach Anspruch 24, **dadurch gekennzeichnet, dass** die Klebestation (34, 51) -in Bahnförderrichtung- vor der Haft- und Kontaktierungsstation (18, 20) der Chipmodule (5) angeordnet ist.

26. Vorrichtung nach Anspruch 25, **dadurch gekennzeichnet, dass** die Klebestation einen Klebemittelauftrag derart steuert, dass lediglich im Bereich der Chipmodule (5) auf der Antennenfolienbahn (1) oder der Schutzfolienbahn (9a) entsprechende Klebeflächen geschaffen werden.

27. Vorrichtung nach einem der Ansprüche 14 bis 26, **dadurch gekennzeichnet, dass** eine Trägerfolienstation (37) vorgesehen ist, an der die Trägerlage (31) in Folienform in aufgewickeltem Zustand vorgelegt ist.

28. Vorrichtung nach einem der Ansprüche 14 bis 27, **dadurch gekennzeichnet, dass** eine Deckfolienstation (39) vorgesehen ist, an der die Decklage (28) in Folienform in aufgewickeltem Zustand vorgelegt ist.

29. Vorrichtung nach Anspruch 27 oder 28, **dadurch gekennzeichnet, dass** eine Klebestation (35, 36) vorgesehen ist, an der ein Klebemittel auf die Decklage und/oder auf die Trägerlage aufgebracht wird.

30. Elektronisches Folienbautell, insbesondere in Form eines Transponders, herstellbar durch ein Verfahren nach einem der Ansprüche 1 bis 14.

## Claims

1. Method for continuously producing electronic film components, in which chip modules (5) are applied with their electrical connecting contacts (3) to antenna connections (2) of antenna film sections (1), to which an antenna structure is in each case assigned, the chip modules (5) being applied with their rear side, facing away from the connecting contacts, to bonding film sections (7) of a base area that is in each case significantly larger than a base area of the associated chip module (5), and the bonding film sections (7) are joined to the antenna film sections (1), one flat on the other, **characterized in that** each bonding film section (7) is provided over its entire inner side, facing the antenna film web (1), with a layer of adhesive (8), so that the bonding film section (7) can be adhesively attached to the antenna film web (1), one flat on the other, around the associated chip module (5), whereby the chip modules (5) are positionally fixed in relation to the antenna connections (2) and the contact between the chip modules (5) and the antenna structures is secured.

2. Method according to Claim 1, **characterized in that**, to produce the film components in the form of transponders, the chip modules (5) are applied to antenna film sections of an antenna film web.

3. Method for continuously producing electronic film components according to Patent Claim 1, **characterized in that**, to produce the film components, electrical connecting contacts of the chip modules are provided with contact tips, in order in a later method step to be respectively brought mechanically into an electrically conductive connection with antenna connections of an antenna structure of an antenna film section, and **in that** the at least one antenna film section is part of a surface of a packaging means.

4. Method according to one of Claims 1 to 3, **characterized in that** a bonding film web (7), provided on one side with a bonding layer (8), is continuously provided at regular intervals with the chip modules (5), and **in that** subsequently the bonding film web (7, 7a) is subdivided into individual bonding film sections, which respectively carry a chip module (5).

5. Method according to Claim 4, **characterized in that** the subdivision of the bonding film web (7, 7a) into individual bonding film sections takes place at a time before the electrical contacting of the chip modules (5) with the antenna connections (2).

6. Method according to one of the preceding claims, **characterized in that** the contact tips of the electrical connecting contacts (3, 4) of the chip modules (5) are mechanically pressed into the electrically conductive antenna connections.

7. Method according to Claim 5, **characterized in that** the bonding film web (7, 7a) and a protective film web (9a) are joined to each other, one flat on the other, and are wound up onto a roll in a composite film web, **in that** the composite film web is unwound from the roll, and **in that** the bonding film web (7a) and the protective film web (9a) are peeled off from each other before application of the chip modules (5) and are fed to different web paths.

8. Method according to Claim 2, **characterized in that** the chip modules (5) applied to the antenna film sections of the antenna film web by means of the bonding film sections are wound up together with the antenna film web onto a roll.

9. Method according to Claim 3, **characterized in that** the chip modules applied to the bonding film web are wound up together with the protective film web onto a roll.

10. Method according to Claim 8, **characterized in that**, before the winding up of the chip modules (5) together with the antenna film web (1), the electrical and/or electronic function of the film components is tested.

11. Method according to one of the preceding claims, **characterized in that** the electrical connecting contacts (3) of the chip modules (5) and/or the antenna connections (2) are provided with substantially pyramidal, hard and conductive particles (49), which are aligned in such a way that tips of the pyramids point in the direction of the corresponding connection.

12. Method according to Claim 2, **characterized in that**, before the electrical contacting of the electrical connecting contacts (3) of the chip modules (5) with the antenna connections (2) and before the joining of the bonding film sections (7, 8) to the antenna film sections (1), an adhesive is applied to the antenna film sections (1) in such a way that, after the electrical contacting and the joining, there forms a layer of adhesive of a minimum extent that is fixed by the boundary surfaces between the chip modules (5) and the antenna film sections (1) and a maximum extent that is fixed by the boundary surfaces between the bonding film sections (7, 8) and the antenna film sections (1).

13. Method according to Claim 2, **characterized in that**, after the electrical contacting of the electrical connecting contacts (3) of the chip modules (5) with the antenna connections (2) and after the joining of the bonding film sections (7, 8) to the antenna film sections (1), a carrier layer (31), in particular a silicone carrier layer, is applied to the antenna film sections (1) and/or a top layer (28) is applied to the bonding film sections (7, 8).

14. Device for carrying out a method according to at least one of the preceding claims, comprising a chip module station (12), at which the chip modules (5) are stored, and also comprising a bonding film station (10, 24), at which the bonding film web (7, 7a) is kept in the form of a roll, a transfer station (15) being provided, at which the chip modules (5) are individually applied with their rear side to the bonding area side (8) of the bonding film web (7, 7a), and the distances between the chip modules (5) when they are applied to the bonding film web being chosen large enough that in each case a bonding film section surrounding the associated chip module (5) is of a much larger surface area than the base area of the respective chip module (5) and is provided with a layer of adhesive (8) on its entire inner side facing the antenna film web (1), and comprising means for adhesively attaching the bonding film section (7) to the upper side of the antenna film web (1), one flat on the other, around the chip module (5) in order to secure the contact between the chip modules (5) and the antenna structures.

15. Device according to Claim 14, **characterized in that** a contact preparation station (13, 13') is provided, at which electrical connecting contacts of the chip modules are provided with contact tips.

16. Device according to Claim 14 or 15, **characterized in that** an antenna film station (19) is provided, at which the antenna film web (1) is kept in a wound-up state.

17. Device according to one of Claims 14 to 16, **characterized in that** a contacting station (18, 20) is provided, for continuous mechanical contacting of the electrical connecting contacts of the chip modules (5) with antenna connections (2) of antenna film sections of the antenna film web (1).

18. Device according to Claim 17, **characterized in that** a bonding station (18, 20) is provided, at which bonding film sections protruding beyond the chip modules (5) are joined to the antenna film sections on which the respective chip module (5) is electrically contacted, one section flat on the other.

19. Device according to one of Claims 14 to 16, **characterized in that** the width of the bonding film web (7a) is greater than the width of the bonding film sections.

20. Device according to one of Claims 14 to 19, **characterized in that** at least one control station (21) is provided, at which the function of the transponders is tested.

21. Device according to one of Claims 14 to 12, **characterized in that** a composite station (23) is provided, at which the antenna film web (1) including the applied chip modules (5) and bonding film sections are wound up on a roll.

22. Device according to one of Claims 14 to 21, **characterized in that** the transfer station has a separating unit (14) for individually separating the chip modules (5) and a turning station (15) for transferring the chip modules (5) with the respective rear side to the bonding film web.

23. Device according to one of Claims 14 to 22, **characterized in that** a separating station (25) is provided, for subdividing the bonding film web (7a) provided with the chip modules (5) into separate bonding film sections.

24. Device according to one of Claims 14 to 23, **characterized in that** an adhesive station (34, 51) is provided, at which an adhesive (53, 54) is applied to the antenna film web (1) or to the protective film web (9a).

25. Device according to Claim 24, **characterized in that** the adhesive station (34, 51) is arranged upstream
- in the web transporting direction - of the bonding and contacting station (18, 20) of the chip modules (5).

26. Device according to Claim 25, **characterized in that** the adhesive station controls an application of adhesive in such a way that appropriate adhesive areas are only created in the region of the chip modules (5) on the antenna film web (1) or the protective film web (9a).

27. Device according to one of Claims 14 to 26, **characterized in that** a carrier film station (37) is provided, at which the carrier layer (31) in the form of a film is kept in a wound-up state.

28. Device according to one of Claims 14 to 27, **characterized in that** a top film station (39) is provided, at which the top layer (28) in the form of a film is kept in a wound-up state.

29. Device according to Claim 27 or 28, **characterized in that** an adhesive station (35, 36) is provided, at which an adhesive is applied to the top layer and/or to the carrier layer.

30. Electronic film component, in particular in the form of a transponder, which can be produced by a method according to one of Claims 1 to 14.

## Revendications

1. Procédé de fabrication en continu de composants électroniques en feuille, dans lequel
des modules de puce (5) sont appliqués par leurs contacts (3) de raccordement électrique sur des bornes d'antenne (2) de segments (1) à chacun desquels est associée une structure d'antenne,
les modules de puce (5) étant appliqués par leur côté dorsal non tourné vers les contacts de raccordement sur des segments (7) de feuille adhésive dont la surface de base est essentiellement plus grande que la surface de base du module de puce (5) associé,
les segments (7) de feuille adhésive étant reliés à plat aux segments (1) de feuille d'antenne, **caractérisé en ce que**
chaque segment (7) de feuille adhésive est doté d'une couche adhésive (8) continue sur son côté intérieur tourné vers la bande (1) de feuille d'antenne, de telle sorte que le segment (7) de feuille adhésive puisse être collé à plat autour du module de puce (5) associé à la bande (1) de feuille d'antenne, grâce à quoi les modules de puce (5) sont immobilisés par rapport aux bornes (2) d'antenne et le contact entre les modules de puce (5) et les structures d'antenne est établi.

2. Procédé selon la revendication 1, **caractérisé en ce que** pour fabriquer des composants de feuille en forme de transpondeurs, les modules de puce (5) sont appliqués sur des segments de feuille d'antenne d'une bande de feuille d'antenne.

3. Procédé de fabrication en continu de composants électroniques en feuille selon la revendication 1, **caractérisé en ce que** pour fabriquer les composants en feuille, des contacts de raccordement électrique de module de puce sont dotés de pointes de contact pour les amener mécaniquement en liaison électriquement conductrice dans une étape de procédé ultérieure avec les bornes d'antenne d'une structure d'antenne d'un segment de feuille d'antenne et **en ce que** le ou les segments de feuille d'antenne font partie de la surface d'un moyen d'emballage.

4. Procédé selon l'une des revendications 1 à 3, **caractérisé en ce qu'**une bande (7) de feuille adhésive dotée d'une couche adhésive (8) sur une face est équipée en continu et à distance régulière des modules de puce (5) et **en ce qu'**ensuite la bande (7, 7a) de feuille adhésive est divisée en segments séparés de feuille adhésive qui portent chacun un module de puce (5).

5. Procédé selon la revendication 4, **caractérisé en ce que** la division de la bande (7, 7a) de feuille adhésive en segments séparés de feuille adhésive s'effectue avant la mise en contact électrique des modules de puce (5) avec les bornes d'antenne (2).

6. Procédé selon l'une des revendications précédentes, **caractérisé en ce que** les pointes de contact des contacts (3, 4) de raccordement électrique des modules de puce (5) sont enfoncés mécaniquement dans les bornes d'antenne électriquement conductrices.

7. Procédé selon la revendication 5, **caractérisé en ce que** la bande (7, 7a) de feuille adhésive et une bande (9a) de feuille de protection sont reliées à plat l'une à l'autre et sont enroulées en bande de feuille composite sur un rouleau, **en ce que** la bande de feuille composite est déroulée du rouleau et **en ce que** la bande (7a) de feuille adhésive et la bande (9a) de feuille de protection sont séparées l'une de l'autre avant le placement des modules de puce (5) et sont amenées par des parcours de bande différents.

8. Procédé selon la revendication 2, **caractérisé en ce que** des modules de puce (5) appliqués au moyen des segments de feuille adhésive sur les segments de feuille d'antenne de la bande de feuille d'antenne sont enroulés en un rouleau en même temps que la bande de feuille d'antenne.

9. Procédé selon la revendication 3, **caractérisé en ce que** les modules de puce appliqués sur la bande de feuille adhésive sont enroulés en un rouleau en même temps que la bande de feuille de protection.

10. Procédé selon la revendication 8, **caractérisé en ce que** le fonctionnement électrique et/ou le fonctionnement électronique des composants en feuille sont vérifiés avant l'enroulement des modules de puce (5) en même temps que la bande (1) de feuille d'antenne.

11. Procédé selon l'une des revendications précédentes, **caractérisé en ce que** les contacts (3) de raccordement électrique des modules de puce (5) et/ou les bornes d'antenne (2) sont dotées de particules (49) essentiellement en forme de pyramide, dures et conductrices, orientées de telle sorte que les pointes des pyramides soient tournées dans la direction de la borne correspondante.

12. Procédé selon la revendication 2, **caractérisé en ce qu'**avant la mise en contact électrique des contacts (3) de raccordement électrique des modules de puce (5) avec les bornes d'antenne (2) et avant la liaison des segments (7, 8) de feuille adhésive avec les segments (1) de feuille d'antenne, un adhésif est appliqué sur les segments (1) de feuille d'antenne de telle sorte qu'après la mise en contact électrique et la liaison, il se forme une couche d'agent adhésif dont l'extension minimale est définie par la surface frontière entre les modules de puce (5) et les segments (1) de feuille d'antenne et dont l'extension maximale est définie par la surface frontière entre les segments (7, 8) de feuille adhésive et les segments (1) de feuille d'antenne.

13. Procédé selon la revendication 2, **caractérisé en ce qu'**après la mise en contact électrique des contacts (3) de raccordement électrique des modules de puce (5) avec les bornes d'antenne (2) et après la liaison des segments (7, 8) de feuille adhésive avec les segments (1) de feuille d'antenne, une couche de support (31), en particulier une couche de support en silicone, est appliquée sur les segments (1) de feuille d'antenne et/ou une couche de recouvrement (28) est appliquée sur les segments (7, 8) de feuille adhésive.

14. Dispositif en vue de l'exécution d'un procédé selon au moins l'une des revendications précédentes, qui présente
un poste (12) à modules de puce sur lequel les modules de puce (5) sont conservés ainsi qu'un poste (10, 24) à feuille adhésive sur lequel la bande (7, 7a) de feuille adhésive est placée en forme de rouleau,
un poste de transfert (15) sur lequel les modules de puce (5) sont appliqués à un à un par leur côté arrière sur le côté (8) de la surface adhésive de la bande (7, 7a) de feuille adhésive,
la distance entre les modules de puce (5) lors de leur application sur la bande de feuille adhésive étant sélectionnée à une valeur suffisamment grande pour qu'un segment de feuille adhésive qui entoure un module de puce (5) associé présente une surface essentiellement plus grande que la surface de base du module de puce (5) concerné et soit doté d'une couche adhésive (8) continue sur son côté intérieur tourné vers la bande (1) de feuille d'antenne et
des moyens de collage à plat du segment (7) de feuille adhésive sur le côté supérieur de la bande (1) de feuille d'antenne autour du module de puce (5) pour établir le contact entre les modules de puce (5) et les structures d'antenne.

15. Dispositif selon la revendication 14, **caractérisé en ce qu'**il présente un poste (13, 13') de préparation des contacts sur lequel les contacts de raccordement électrique des modules de puce sont dotés de pointes de contact.

16. Dispositif selon les revendications 14 ou 15, **caractérisé en ce qu'**il présente un poste (19) à feuille d'antenne sur lequel la bande (1) de feuille d'antenne est placée à l'état enroulé.

17. Dispositif selon l'une des revendications 14 à 16, **caractérisé en ce qu'**il présente un poste (18, 20) de mise en contact qui assure en continu la mise en contact mécanique des contacts de raccordement électrique des modules de puce (5) avec les bornes d'antenne (2) de segments de feuille d'antenne de la bande (1) de feuille d'antenne.

18. Dispositif selon la revendication 17, **caractérisé en ce qu'**il présente un poste de collage (18, 20) sur lequel des segments de feuille adhésive qui débordent au-delà des modules de puce (5) sont reliés aux segments de feuille d'antenne sur chacun desquels un module de puce (5) est mis en contact électrique.

19. Dispositif selon l'une des revendications 14 à 16, **caractérisé en ce que** la largeur de la bande (7a) de feuille adhésive est supérieure à la largeur des segments de feuille adhésive.

20. Dispositif selon l'une des revendications 14 à 19, **caractérisé en ce qu'**il présente au moins un poste de contrôle (21) sur lequel le fonctionnement du transpondeur est vérifié.

21. Dispositif selon l'une des revendications 14 à 12, **caractérisé en ce qu'**il présente un poste de liaison (23) sur lequel la bande (1) de feuille d'antenne est enroulée en un rouleau en même temps que le module de puce (5) et que les segments de feuille adhésive qui y sont appliqués.

22. Dispositif selon l'une des revendications 14 à 21, **caractérisé en ce que** le poste de transfert présente une unité de séparation (14) qui sépare un à un les modules de puce (5) ainsi qu'un poste de bobinage (15) qui transfère les modules de puce (5) avec leur côté arrière sur la bande de feuille adhésive.

23. Dispositif selon l'une des revendications 14 à 22, **caractérisé en ce qu'**il présente un poste de séparation (25) qui divise la bande (7a) de feuille adhésive dotée des modules de puce (5) en segments séparés de feuille adhésive.

24. Dispositif selon l'une des revendications 14 à 23, **caractérisé en ce qu'**il présente un poste de collage (34, 51) sur lequel un adhésif (53, 54) est appliqué sur la bande (1) de feuille d'antenne ou sur la bande (9a) de feuille de protection.

25. Dispositif selon la revendication 24, **caractérisé en ce que** le poste de collage (34, 51) est disposé en amont du poste de collage et du poste de mise en contact (18, 20) des modules de puce (5) dans la direction de transport de la bande.

26. Dispositif selon la revendication 25, **caractérisé en ce que** le poste de collage commande l'application d'un adhésif de telle sorte que des surfaces adhésives appropriées soient formées uniquement dans la zone occupée par les modules de puces (5) sur la bande (1) de feuille d'antenne ou sur la bande (9a) de feuille de protection.

27. Dispositif selon l'une des revendications 14 à 26, **caractérisé en ce qu'**il présente un poste (37) à feuille de support sur lequel la couche de support (31) est placée en forme de feuille à l'état enroulé.

28. Dispositif selon l'une des revendications 14 à 27, **caractérisé en ce qu'**il présente un poste (39) à feuille de recouvrement sur lequel la couche de recouvrement (28) en forme de feuille est placée à l'état enroulé.

29. Dispositif selon les revendications 27 ou 28, **caractérisé en ce qu'**il présente un poste de collage (35, 36) sur lequel un adhésif est appliqué sur la couche de recouvrement et/ou sur la couche de support.

30. Composant électronique en feuille, qui présente en particulier la forme d'un transpondeur, fabriqué par un procédé selon l'une des revendications 1 à 14.
